# EUROPEAN PATENT SPECIFICATION

(11) **EP 4 365 736 B1**
(45) Date of publication and mention of the grant of the patent: **28.01.2026**
(21) Application number: 22205712.7
(22) Date of filing: 07.11.2022
(51) Int. Cl.: G06F 9/48, G06F 9/50

(54) **THREE-DIMENSIONAL REALITY CAPTURING OF AN ENVIRONMENT BY A SURVEYING DEVICE AND DISTRIBUTED PROCESSING WITH IMPROVED PROVISION OF A PREVIEW OF A DIGITAL MODEL OF THE ENVIRONMENT**
DREIDIMENSIONALE REALITÄTSERFASSUNG EINER UMGEBUNG DURCH EIN VERMESSUNGSGERÄT UND VERTEILTES VERARBEITEN MIT VERBESSERTER VORSCHAU EINES DIGITALEN UMGEBUNGSMODELLS
CAPTURE DE RÉALITÉ TRIDIMENSIONNELLE D'UN ENVIRONNEMENT PAR UN DISPOSITIF DE SURVEILLANCE ET TRAITEMENT DISTRIBUÉ AVEC FOURNITURE AMÉLIORÉE D'UNE PRÉVISUALISATION D'UN MODÈLE NUMÉRIQUE DE L'ENVIRONNEMENT

(43) Date of publication of application: 08.05.2024
(73) Proprietor: Hexagon Innovation Hub GmbH, 9435 Heerbrugg (CH)
(72) Inventor: MAUNZ, Johannes, CH-9445 Rebstein (CH); TRIEGEL, Henk, CH-9435 Heerbrugg (CH); BÖSCH BORGARDS, Tobias, CH-9053 Teufen (CH)
(74) Representative: Kaminski Harmann

(56) References cited:
- ISLAM BASHIMA ET AL: "Glimpse.3D: A Motion-Triggered Stereo Body Camera for 3D Experience Capture and Preview", 2018 17TH ACM/IEEE INTERNATIONAL CONFERENCE ON INFORMATION PROCESSING IN SENSOR NETWORKS (IPSN), IEEE, 11 April 2018 (2018-04-11), pages 176 - 187, XP033411193, DOI: 10.1109/IPSN.2018.00046

## Description

The present invention generally relates to three-dimensional reality capturing of an environment, wherein spatial three-dimensional scan data are provided by a surveying device and processing of the scan data is distributed among a group of processing participants to provide a three-dimensional model of the environment.

By way of example, three-dimensional surveying is used to assess an actual condition of an area of interest, e.g. a restricted or dangerous area such as a construction site, an industrial plant, a business complex, or a cave. The outcome of the 3D surveying may be used to efficiently plan next work steps or appropriate actions to react on a determined actual condition.

Decision making and planning of work steps is further aided by means of a dedicated digital visualization of the actual state, e.g. in the form of a point cloud or a vector file model, or by means of an augmented reality functionality making use of the 3D surveying data.

3D surveying often involves optically scanning and measuring an environment by means of a laser scanner, which emits a laser measurement beam, e.g. using pulsed electromagnetic radiation. By receiving an echo from a backscattering surface point of the environment a distance to the surface point is derived and associated with an angular emission direction of the associated laser measurement beam. This way, a three-dimensional point cloud is generated. For example, the distance measurement may be based on the time of flight, the shape, and/or the phase of the pulse.

For additional information, the laser scanner data may be combined with camera data, in particular to provide high-resolution spectral information, e.g. by means of an RGB camera or an infrared camera.

Nowadays, robotic vehicles, particularly autonomous robotic vehicles, are increasingly used to facilitate data acquisition and to reduce risks on human workers. 3D surveying devices used in combination with such robotic vehicles are typically configured to provide surveying data during movement of the robotic vehicle, wherein referencing data provide information on a trajectory of a data acquisition unit, e.g. position and/or pose data, such that surveying data acquired from different positions of the data acquisition unit can be combined into a common coordinate system.

The 3D surveying data may then be analyzed by means of a feature recognition algorithm for automatically recognizing semantic and/or geometric features captured by the surveying data, e.g. by means of using shape information provided by virtual object data from a CAD model. Such feature recognition, particularly for recognizing geometric primitives, are nowadays widely used to analyze 3D data.

The data used to generate a 3D model are multifarious. For example, airborne surveying devices, such as the Leica BLK2FLY, provide photogrammetry data and/or lidar data to generate a three-dimensional model, e.g. a point cloud or a vector file model, of the overflown terrain. The aerial data may be complemented by ground based mobile mapping data - e.g. provided by devices such as the Leica Pegasus:Backpack, the Leica Pegasus:Two, or the Leica BLK2GO - or by high-end laser scanning stations such as the Leica RTC360 or the Leica BLK360.

Given the large amount of data and the different kinds of data, data acquisition, data handling, and selection of relevant data may be cumbersome and, for example, require long user experience. Different kinds of user may have different requirements or prerequisites regarding data quality and accuracy, data storage and computing power, and 3D model visualization. Often sophisticated software and an advanced skill level of the user is required to provide acquisition and processing of scan data with sufficient quality.

A system of the prior art is described in Islam Bashima et al. "Glimpse.3D: A Motion-Triggered Stereo Body Camera for 3D Experience Capture and Preview", 2018 17th ACM/IEEE International Conference on Information Processing in Sensor Networks, pages 176-187 (DOI: 10.1109/IPSN.2018.00046).

It is therefore an object of the present invention to provide three-dimensional reality capturing of an environment, which provides easier data acquisition and easier assessment of data quality, e.g. such that a required level of expertise to acquire the data and to assess the data quality becomes more relaxed.

A further object is to provide more efficient acquisition of surveying data, e.g. acquisition of surveying data of sufficient data quality in less time and with generation of less data overhead.

The invention is set out in the appended set of claims.

The invention relates to a method for providing a digital model of an environment based on scan data provided by a 3D surveying device, wherein the scan data provide spatial 3D information of the environment. For example, the scan data are provided by an optical sensor, e.g. a lidar sensor or a white light sensor cell.

By way of example, the scan data are provided by at least one of an aerial 3D reality capture device such as the Leica BLK2FLY, a ground based reality capture device such as the Leica Pegasus:Backpack, the Leica Pegasus:Two, or the Leica BLK2GO, and a high-end laser scanning station such as the Leica RTC360 or the Leica BLK360.

The processing of the scan data is distributed among a group of processing participants comprising the 3D surveying device, a cloud processing unit, and a client device, e.g. a smartphone or tablet or a personal computer, wherein the processing participants are configured for data exchange with one another and to execute at least part of the processing of the scan data to provide the digital model. The method thus relates to a specific way of causing the processing participants to execute different processing steps to provide the digital model and of displaying a representation of the digital model, e.g. on a display of the 3D surveying device or on a display of the client device.

According to one aspect of the invention, a scan task to be currently executed by the 3D surveying device and an associated model type of the digital model of the environment to be provided by the scan data are derived. For example, the scan task and/or the associated model type is/are derived by user input. Alternatively, or in addition, the scan task is determined by analyzing a motion state history and/or an operation history of the 3D surveying device to provide an estimate of a further motion state and/or operating condition of the 3D surveying device.

The model type is then associated to visualization criteria for a display of a representation of a preview of the digital model. By way of example, the visualization criteria provide a minimum level of detail of the preview such that a user is able to quickly assess a quality of the data acquisition. For example, a user wants to have a quick feedback on whether the environment is measured with sufficient detail, e.g. without shadowing areas caused by line-of-sight blockage. The visualization criteria may further be configured to allow indication of estimated quality parameters to different areas in the preview, e.g. estimated final point densities or distance measuring accuracies, or an indication of involved data types that provide useful content.

Minimal processing units of the processing of the scan data are derived, wherein the minimal processing units provide the display of the representation of the preview of the digital model in a way that it fulfils the visualization criteria. A prioritization algorithm is used to dynamically distribute different processing assignments for processing the scan data among the processing participants, wherein the prioritization algorithm is configured to provide an optimization in terms of definition and distribution of the different processing assignments. The optimization has a short time to provide the minimum processing units as a target value and a currently available bandwidth and connection stability of a data exchange between the processing participants with one another, a currently available computing power on each of the processing participants, and remaining battery power on the 3D surveying device as input parameters.

By taking into account currently available bandwidth, connection stability, computing power of each participant, and remaining battery power on the 3D surveying device, processing is quickly adapted to a quickly changing status of the complete surveying system, i.e. from data acquisition to data processing in order to provide fast preview and feedback possibility to the user.

Fast preview, particularly visual preview, of the digital model to be generated allows quick assessment and adaption of the data acquisition process, even without special training.

In one embodiment, the associating of the model type to the visualization criteria comprises a selecting between visualization criteria providing a reachable quality of the display of the representation of the preview of the digital model on the basis of a currently available data quality of the scan data and visualization criteria providing a defined target quality of the display of the representation of the preview of the digital model. For example, the defined target quality is a maximally reachable target quality in a defined time window. In other words, a user can select an option "minimum time from scan to visualize" (e.g. by accepting a currently available "intrinsic" data quality) or an option "visualize as quick as possible with a defined visualization quality".

In a further embodiment, the optimization comprises a long battery power on the 3D surveying device as further target value, and the prioritization algorithm is configured to provide an adjustment option to adjust a weighting of the target value "short time to provide the minimum processing units" relative to the further target value "long battery power on the 3D surveying device". For example, more weight on the further target value "long battery power on the 3D surveying device" causes a reduction of local computation on the 3D surveying device, e.g. wherein on-device processing is limited to a minimum.

In a further embodiment, the input parameters further comprise an internal temperature parameter of the 3D surveying device, e.g. a heat gradient within the 3D surveying device determined each ten seconds. For example, the prioritization algorithm is configured to take into account the internal temperature parameter to estimate the remaining battery power on the 3D surveying device, e.g. by estimating a degradation of battery life of a battery of the 3D surveying device.

In a further embodiment, a history of a battery life is derived as a function of on-device computation load of at least one of the 3D surveying device and the client device, wherein the optimization takes into account the history of the battery life as a function of on-device computation load, e.g. by means of a consensual decision rule. For example, a so-called "normal" decision in computing remaining battery power is a straight forward linear optimization. However, based on experience (e.g. average duration vs. predicted, average failure rate of a scan) in a consensual decision rule this decision is altered (e.g. based on experience, does the battery even work long enough?).

In a further embodiment, the method comprises a deriving of a recommendation by the 3D surveying device with regard to definition and/or distribution of the different processing assignments, wherein the prioritization algorithm is configured to take into account the recommendation by the 3D surveying device for providing the definition and distribution of the different processing assignments.

In particular, the recommendation by the 3D surveying device is triggered by a change in an operating condition of the 3D surveying device. For example, this provides the benefit that changing a condition of the 3D surveying device that potentially has a direct impact on the end-to-end processing efficiency, e.g. setting the surveying device from a low point density mode to a high point density mode, can be taken into account essentially in real time, without a need of constantly querying all of the processing participants.

Similarly, a recommendation of a processing by the client device with regard to available processing by the client device may be derived, wherein the prioritization algorithm is configured to take into account the recommendation by the client device for providing the definition and distribution of the different processing assignments. For example, the recommendation by the client device is triggered by a change in an operating condition of the client device.

In a further embodiment, the deriving of the scan task and the associating of the model type to the visualization criteria are executed by a comparison of the scan data with a plurality of workflows stored on a workflow database, wherein each workflow is defined by a data format and/or an acquisition parameter of the scan data and a target format of the digital model.

For example, each workflow is associated with multiple fragmentation options to split the processing of the scan data into fragments to provide the target format of the digital model, wherein each fragment is associated with processing costs that provide information on computation requirements, processing time, power consumption, and data exchange needs. The prioritization algorithm is configured to carry out a comparison of the processing costs of the fragments with the currently available bandwidth and connection stability of the data exchange between the processing participants with one another, the currently available computing power on each of the processing participants, and the remaining battery power on the 3D surveying device and the client device. On the basis of that, the prioritization algorithm calculates a processing time to provide the minimal processing units with different permutations of the multiple fragmentation options.

The invention further relates to a surveying system comprising a 3D surveying device, a cloud processing unit, and a client device as described above, wherein the system is configured for carrying out the method as described above with reference to the use of a surveying device, a cloud processing unit, and a client device.

In other words, the 3D surveying device provides the scan data of the step of distributing processing of the scan data among a group of processing participants described above; and the 3D surveying device, the cloud processing unit, and the client device are part of the group of processing participants of the step of distributing processing of the scan data among a group of processing participants described above.

In one embodiment, the system further comprises a user interface configured to provide an input functionality to provide execution of the step of selecting between visualization criteria providing a reachable quality of the display of the representation of the preview of the digital model on the basis of a currently available data quality of the scan data and visualization criteria providing a defined target quality of the display of the representation of the preview of the digital model.

Alternatively or in addition, the user interface is configured to provide an option for providing a weighting change to be used by the adjustment option to adjust a weighting of the target value relative to the further target value as described above.

The invention further relates to a computer program product comprising program code stored on a machine-readable medium or being embodied by an electromagnetic wave comprising a program code segment, wherein the program code comprises a prioritization algorithm configured to provide definition of different processing assignments for processing scan data of a 3D surveying device and distribution of the different processing assignments among processing participants comprising the 3D surveying device, a cloud processing unit, and a client device. The program code further comprises computer-executable instructions for performing the following steps, e.g. when executed in a surveying system as described above: deriving a scan task to be currently executed by the 3D surveying device and an associated model type of a digital model of an environment to be provided by the scan data; associating the model type to visualization criteria for a display of a representation of a preview of the digital model; deriving minimal processing units for processing the scan data to provide the display of the representation of the preview of the digital model in a way that it fulfils the visualization criteria; and using the prioritization algorithm to provide dynamic distribution of the different processing assignments among the processing participants. In order to provide these steps, the prioritization algorithm is configured to provide an optimization in terms of definition and distribution of the different processing assignments with a short time to provide the minimum processing units as a target value and with a currently available bandwidth and connection stability of a data exchange between the processing participants with one another, a currently available computing power on each of the processing participants, and remaining battery power on the 3D surveying device as input parameters.

In particular, the program code comprises computer-executable instructions for performing any one of the computational steps in the method described above.

The method and system according to the different aspects of the invention are described or explained in more detail below, purely by way of example, with reference to working examples shown schematically in the drawing. Identical elements are labelled with the same reference numerals in the figures. The described embodiments are generally not shown true to scale and they are also not to be interpreted as limiting the invention. Specifically,
- Fig. 1:: an exemplary measurement scenario, wherein multiple surveying devices are used to generate scan data of an environment;
- Fig. 2:: another exemplary measurement scenario, wherein the surveying device is embodied as a handheld reality capture device;
- Fig. 3:: an exemplary embodiment of a lidar device in the form of a so-called two-axis laser scanner to be used for generating scan data;
- Fig. 4:: an exemplary workflow to provide a digital model of the environment according to the invention, wherein processing of scan data from one or a plurality of surveying devices is distributed among the one or the plurality of surveying devices, a cloud processing unit, and one or a plurality of client devices;
- Fig. 5:: an exemplary processing situation with overall high available bandwidths between the processing participants;
- Fig. 6:: another exemplary processing situation, wherein the surveying devices and a client device only provide limited computing power and reduced battery charging, wherein fast connectivity to the cloud processing unit is available;
- Fig. 7:: another exemplary processing situation, wherein connectivity to the cloud is limited;
- Fig. 8:: a schematic workflow to determine the minimal processing units and to distribute the minimal processing units among the processing participants;
- Fig. 9:: a schematic depiction of a decision making process within a further embodiment of the invention.

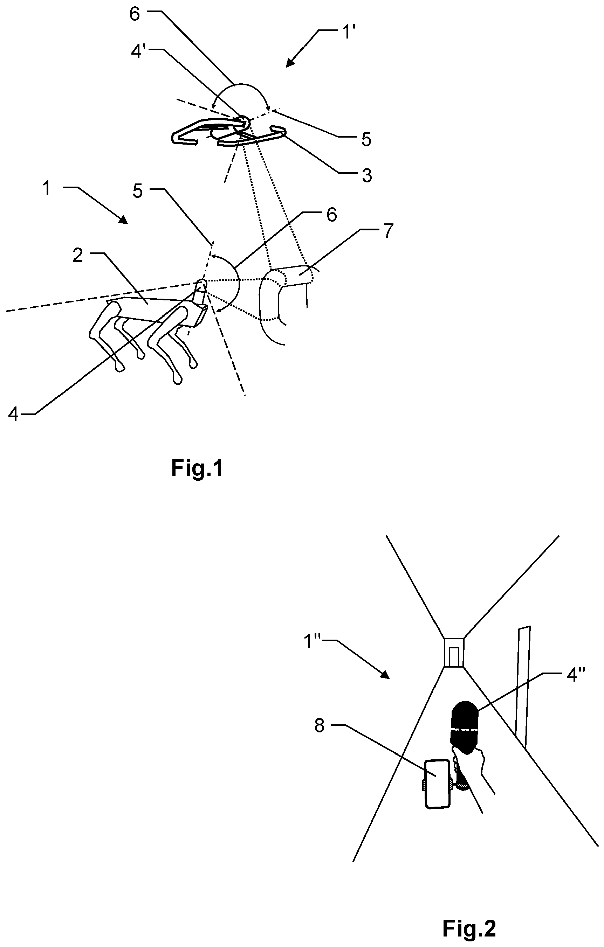

**Figure 1** depicts an exemplary measurement scenario, wherein multiple surveying devices 1, 1' are used to generate scan data of an environment in order to determine a digital model of the environment.

By way of example, one surveying device 1 is mounted on an unmanned ground vehicle (UGV) 2 and works together with a further surveying device 1' mounted on an unmanned aerial vehicle (UAV) 3. Each of the UGV 2 and the UAV 3 is equipped with a lidar device 4, 4'.

Here, the robotic ground vehicle 2 is embodied as a four-legged robot. For example, such robots are often used in unknown terrain with different surface properties having debris and steep inclines. The ground robot 2 has sensors and processing capabilities to provide for simultaneous localization and mapping (SLAM), which comprises reception of perception data providing a representation of the surroundings of the autonomous ground robot 2 at a current position, use of the perception data to generate a map of the environment, and determination of a trajectory of a path that the ground robot 2 has passed within the map of the environment.

The aerial vehicle 3 is embodied as quadcopter drone, which allows further versatility to survey areas that are difficult or impossible to access by the robotic ground vehicle 2. Similarly to the UGV 2, the aerial vehicle 3 has sensors and processing capabilities to provide for simultaneous localization and mapping, which comprises reception of perception data providing a representation of the surroundings of the unmanned aerial vehicle 3 at a current position, use of the perception data to generate a map of the environment, and determination of a trajectory of a path that the aerial vehicle 3 has passed within the map of the environment.

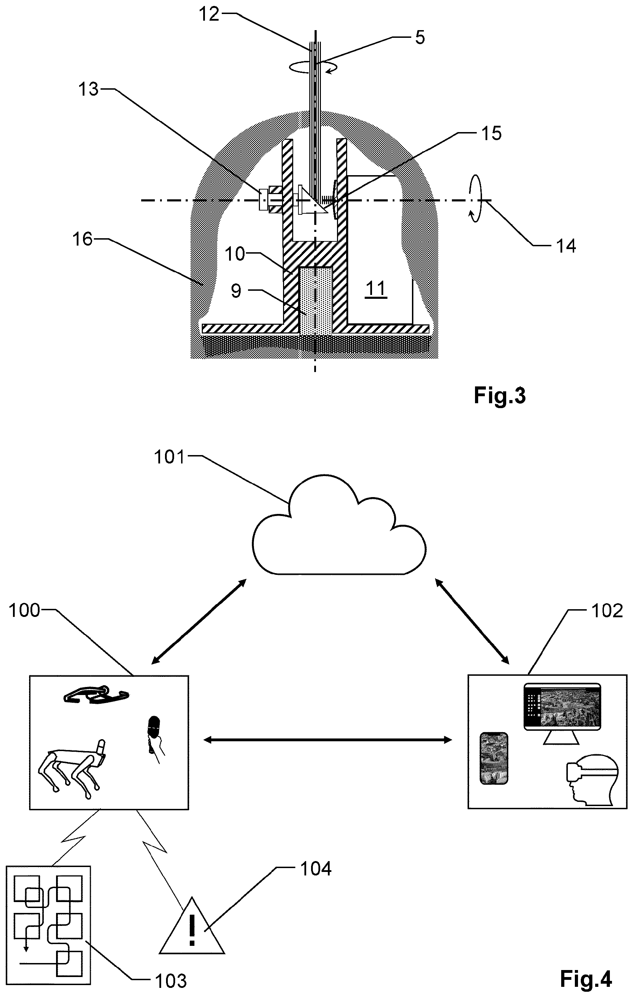

Each of the lidar devices 4, 4' has a field-of-view of 360 degrees about a so-called slow axis 5 and a so-called band field-of-view 6 of at least 130 degrees about a fast axis (see Fig. 3). Both lidar devices 4, 4' are each configured to generate the corresponding lidar data with a point acquisition rate of at least 300'000 points per second. For example, the lidar devices 4, 4' are each embodied as so-called two-axis laser scanner (see Fig. 3), wherein in case of the lidar device 4 on the UGV, the fast axis 5 is essentially aligned vertical and in case of the lidar device 4' on the UAV, the fast axis 5 is essentially aligned horizontal.

By way of example, the SLAM units of the UGV and the UAV respectively, are configured to receive the corresponding lidar data as the perception data, which, for example, provides improved field-of-view and viewing distance and thus improved larger scale path determination. For example, this is particularly beneficial for exploring unknown terrain. Another benefit comes with the all-around horizontal field-of-view about the slow axis 5 and the band field-of-view 6 of 130 degrees about the fast axis. In case of the UGV 2 this provides the capability to essentially cover the front, the back, and the ground at the same time, wherein in case of the UAV 3 this provides the capability to essentially cover the back and the ground at the same time.

By way of example, the lidar data generated by means of the UGV can be combined for gap-filling of complimentary system data. Typically, the UGV lidar device "sees" objects close to the ground and in a side perspective (facades, soffit, etc.) and is used for indoor surveying (buildings, tunnels, etc.). The UAV observes objects above ground (upper level facades, roof, etc.) and is often used for outdoor surveying (buildings, bridges, etc.). In the figure, both the UAV lidar device 4' and the UGV lidar device 4 are exemplarily used to coordinatively measure a pipe 7, e.g. on a power plant site, wherein the UAV lidar device 4' predominantly observes the top part of the pipe 7 and the UGV lidar device 4 only observes the pipe 7 from a side perspective.

The combination of a UGV 1 and a UAV 2 further allows to carry out a scan area definition for the lidar device 4 on the UGV by means of an exploration flight of the UAV 2. By the exploration flight, a region of interest to be surveyed by the UGV is defined. For example, the UAV 2 provides for generation of an overview of path, where UGV 1 is following. Spatial anchoring (re-localization) allows matching of the UGV lidar data and the UAV lidar data and trajectory alignment for line-of-sight environments.

The exploration by the UAV also allows to estimate if a particular measurement goal can be reached with constraints, e.g. providing for an improved estimate whether the battery of the UAV 2 or the UGV 1 is enough to fulfill a foreseen task. Since battery power of a UAV is typically limited, the UGV 1 may further be configured as landing/docking station for the UAV 2 and as a moving charging station for the UAV 2. This way the reach by the UAV 2 can be extended by re-charging, e.g. during periods where only surveying by the UGV lidar device 4 is required, e.g. when stepping in an indoor environment. Similarly, while heavy data download may be preferably carried out in a docked state of the UAV 2 on the UGV 1.

**Figure 2** depicts another exemplary measurement scenario, wherein the surveying device 1" is embodied as a handheld reality capture device 1" configured to generate scan data of the environment.

By way of example, the handheld reality capture device 1" comprises a localization unit, e.g. an inertial measurement unit (IMU), wherein the localization unit is configured for generating localization data for determining a trajectory of the hadheld reality capture device. In particular, the handheld mobile reality capture device 1" may be configured for simultaneous localization and mapping (SLAM) by involving at least one of data of the IMU, image data of a camera unit for visual simultaneous localization and mapping (VSLAM), and lidar data for lidar based simultaneous localization and mapping (LIDAR-SLAM).

The handheld reality capture device 1" further comprises a laser scanner 4" configured to carry out, during movement of the handheld reality capture device 1", a scanning movement of a laser measurement beam relative to two rotation axes, and, based thereof, to generate light detection and ranging (lidar) data for generating a three-dimensional point cloud. For example, the localization data may be based on at least part of the lidar data.

The handheld reality capture device 1" may further comprise a panoramic camera unit arranged on a lateral surface of the reality capture device, the lateral surface defining a standing axis of the handheld reality capture device, namely wherein the lateral surface is circumferentially arranged around the standing axis. The panoramic camera unit is configured to provide for image data which cover a visual field of at least 120° around the standing axis, particularly at least 180°, more particularly 360°.

A measurement progress or operating information may be provided to the user by means of a client device 8, e.g. an attachable companion device such as a smartphone or tablet, which is in wireless communication with the handheld reality capture device.

For surveying a user walks the handheld reality capture device 1" through the environment while the laser scanner 4" acquires 3D point cloud data. Such a mobile measurement by hand-held or backpack-supported lidar-based reality capture devices, e.g. such as the Leica Pegasus:Backpack, the Leica Pegasus:Two, or the Leica BLK2GO, a new range of problems arise compared to stationary laser scanners. Particular problems relate to the handling of changing environmental conditions such as changes of surface reflectivity, which requires the lidar sensor to be able to cope with large dynamic ranges, i.e. the range from the lowest measureable intensity level to the highest measurable intensity level. The close distance between surveyor and device causes shading in the acquired point clouds, requiring the surveyor to learn specific gestures or movements when operating the device in different measurement scenarios to ensure smooth operation and sufficient data quality. For example, such measurement scenarios include walking next to a wall, walking through a long corridor, opening a door, or walking stairs or a ramp downstairs.

By way of example, when walking next to a wall the surveyor should keep the device in the hand, which is farther away from the wall. This might require a change of hands in which the device is hold. When opening a door or walking through a long corridor the device should be lifted up and to the side so that the device is not blocked by the surveyor's body and receives more data points from behind the surveyor to improve the SLAM algorithm. For example, this is required because for a long corridor the end of the corridor might be too far away leaving only the walls on the side for the SLAM process which might not be enough. When opening a door there is a sudden change in the environment with many new data points being recorded as soon as the door opens, which makes localization difficult. When walking downstairs the device needs to be tilted down such that the region of measurement of the laser scanner still "reaches" the stairs/floor and covers data points from there. The user should either walk upstairs or tilt the device down far enough that the stairs are visible to the device's sensors. Further problem areas may be (list is not exhaustive) detection of drops of the device, measuring during turns, walking too slow or too fast, differences between skill level of operator, differences between left-handed and right-handed movements, etc.

Similar problems may arise in case the mobile reality capture device is arranged on a robotic vehicle, e.g. an autonomously moving ground-based or aerial vehicle. By way of example, the mobile reality capture device may be carried by a legged robot, e.g. a four-legged robot, which is often able to freely move in a building because it can handle obstacles such as staircases. Another possibility would be to use aerial drones, e.g. quadcopter drones, which allow further versatility to survey areas that are difficult to access, but often to the expense of less surveying time and/or sensor complexity due to limited load capacity and battery power.

**Figure 3** shows an exemplary embodiment of a lidar device in the form of a so-called two-axis laser scanner to be used for generating scan data. The laser scanner comprises a base 9 and a support 10, the support 10 being rotatably mounted on the base 9 about the slow axis 5. Often the rotation of the support 10 about the slow axis 5 is also called azimuthal rotation, regardless of whether the laser scanner, or the slow axis 5, is aligned exactly vertically.

The core of the laser scanner is an optical distance measuring unit 11 arranged in the support 10 and configured to perform a distance measurement by emitting a pulsed laser beam 12, e.g. wherein the pulsed laser beam comprises 1.5 million pulses per second, and by detecting returning parts of the pulsed laser beam by means of a receiving unit comprising a photosensitive sensor. Thus, a pulse echo is received from a backscattering surface point of the environment, wherein a distance to the surface point can be derived based on the time of flight, the shape, and/or the phase of the emitted pulse.

The scanning movement of the laser beam 12 is carried out by rotating the support 10 relative to the base 9 about the slow axis 5 and by means of a rotating body 13, which is rotatably mounted on the support 10 and rotates about a so-called fast axis 14, here a horizontal axis. By way of example, both the transmitted laser beam 12 and the returning parts of the laser beam are deflected by means of a reflecting surface 15 integral with the rotating body 13 or applied to the rotating body 13. Alternatively, the transmitted laser radiation is coming from the side facing away from the reflecting surface, i.e. coming from the inside of the rotating body 13, and emitted into the environment via a passage area within the reflecting surface.

For the determination of the emission direction of the distance measuring beam 12 many different angle determining units are known in the prior art. For example, the emission direction may be detected by means of angle encoders, which are configured for the acquisition of angular data for the detection of absolute angular positions and/or relative angular changes of the support 10 or of the rotating body 13, respectively. Another possibility is to determine the angular positions of the support 10 or the rotating body 13, respectively, by only detecting full revolutions and using knowledge of the set rotation frequency.

By way of example, all rotating parts are arranged behind a cover 16, which is transparent for the distance measuring beam 12 and provides protection of mechanical and optical parts of the laser scanner.

A visualization of the data can be based on commonly known data processing steps and/or display options, e.g. wherein the acquired data is presented in the form of a 3D point cloud or wherein 3D vector file model is generated.

The laser scanner is configured to ensure a total field of view of the measuring operation of the laser scanner of 360 degrees in an azimuth direction defined by the rotation of the support 10 about the slow axis 5 and at least 130 degrees in a declination direction defined by the rotation of the rotating body 13 about the fast axis 14. In other words, regardless of the azimuth angle of the support 10 about the slow axis 5, the laser beam 12 can cover a so-called band field of view, in the figure a vertical field of view, spread in the declination direction with a spread angle of at least 130 degrees.

By way of example, the total field of view typically refers to a central reference point of the laser scanner defined by the intersection of the slow axis 5 with the fast axis 14.

**Figure 4** schematically depicts an exemplary workflow to provide a digital model of the environment according to the invention, wherein processing of scan data from one or a plurality of surveying devices 100 is distributed among the one or the plurality of surveying devices 100, a cloud processing unit 101, and one or a plurality of client devices 102.

By way of example, the one or the plurality of surveying devices 100 comprises a surveying device embodied as one of the surveying devices 1, 1', 1" described with reference to Figs. 1 to 3. The one or the plurality of client devices 102 may comprise a personal computer, a smartphone, or a tablet.

The processing participants 100, 101, 102 are configured for data exchange with one another and to execute at least part of the processing of the scan data to provide the digital model.

Often, handling of the surveying devices 100 requires user experience, e.g. an advanced skill level of the user, to provide best scan results. Carrying out correct scan movements and suitable device settings is not straight-forward, while processing of the data is time intensive. Thus, a user is often provided with limited feedback from the surveying devices about a current data quality or scanning coverage.

In order to provide an early preview of the data quality and the estimated end product (the digital model of the environment), processing is adapted to provide a dynamic distribution of processing unts required for generating the preview, wherein the time to provide the preview is minimized by taking into account, e.g. in real time, current local restrictions on power capacities, computing capacities, and transmission bandwidths of the processing participants 100, 101, 102.

First, a current scan task is defined or determined, for the completion of which a temporal and spatial allocation of processing units is made, wherein processing (computing power, availability, etc.), transmission (bandwidth, stability of the connection, etc.) and sensor (battery status, computing power, etc.) costs are taken into account.

By way of example, if no current scan task is specified by the user, e.g. wherein the user just starts scanning, a statistical analysis of the behavior of the user is carried out, on the basis of which a current measurement situation is determined and an estimated behavior associated with a defined scan task is determined. For example, the user may then be provided with information on the estimated scan task, e.g. for verification, and/or the user may be automatically provided with appropriate user guidance (e.g. a proposed scan path, walking speed, available time window to complete the scan task, etc.) by a user guidance interface the device

Based on the derived scan task to be currently executed, a model type of the digital model of the environment is determined. For example, the scan task may be associated with providing of a particular level of detail of the digital model to be generated. The scan task may be typical for providing data of two particular surveying devices working together to fuse different data types, e.g. to gain information content such as geometrical information combined with a color or temperature information of objects within the environment. Based on the scan task, the system may automatically recognize a target quality to be achieved, e.g. a minimal overall point density or a minimal signal-to-noise in the coordinate measuring data underlying the digital model.

Having defined the model type of the digital model to be generated, visualization criteria are determined, which provide for a display of a representation of a preview of the digital model such that a user is able to assess a status of the scan task. By way of example, the visualization criteria provide for a preview, which allows to assess a progress of the scan task, e.g. together with information on parameters which define the model type. For example, in case the model type is typical for being based on a fusion of different data types, parameters indicative of a matching suitability of the data are provided, e.g. a level of spatial overlap of the different data. In case the model type defines a heat map, the preview may require information such as temperature and color associated to different objects represented by the digital model. Depending on the model type, different quality indicators have to be provided to the user such that the user is able to assess a currently reached and/or estimated data quality.

The focus then lies on prioritizing the processing of the spatial data to provide the preview as quickly as possible. In order to do so, minimal processing units of the processing of the scan data are derived, which provide for a display of the preview of the digital model in a way that it fulfils the visualization criteria.

The minimal processing units are then dynamically distributed among the processing participants 100, 101, 102, wherein potential bottlenecks occurring because of limited bandwidth, connection stability between the participants, and current computation load on the participants, e.g. computation load due to higher ranked computation processes such as security protocols or other parallel processing differentiating from the processing of the scan data, are taken into account. In addition, remaining battery power of the one or the plurality of surveying devices 100, and optionally of the one or the plurality of client devices 102, is taken into account, e.g. wherein power intensive computing is minimized in case of low battery power in order to make sure that the scan task can be completed / is not interrupted because due to a power failure.

By way of example, further constraints for prioritizing and distributing the processing of the minimal processing units are provided by local information provided by the one or the plurality of surveying devices 100 and by the one or the plurality of client devices 102, respectively.

For example, each of the surveying devices 100 has knowledge on current bandwidth of connection speed and has upfront information on a current scan, e.g. based on trajectory information. Thus, a first estimation of the amount of data to process can be made by the surveying device, e.g. an estimation of the required computing power to handle a current SLAM calculation 103, point cloud cleaning, and mesh generation. For example, in case the current environment provides for sufficient features suitable for the SLAM process, e.g. to find and track in a form of a so-called sparse point cloud, the SLAM calculation may be efficiently executed and may be carried out on the device as a matter of priority. In particular, it may be desirable, e.g. for security and stability reasons, that SLAM processing is carried out on the corresponding surveying device 100 whenever possible. In particular, a sudden change in operating condition 104, e.g. due to an external influence or environment change or due to user input, is communicated to other participants 100, 101, 102 in real time.

The one or the plurality of surveying devices 100 may provide a first estimate of a scan duration and required computing power, e.g. based on local information gathered by the devices. The battery and internal temperature conditions can be uploaded regularly, e.g. each ten seconds, to provide the system with close to real time information.

The local information by the one or the plurality of surveying devices 100 may provide for a local optimization recommendation for the execution of the scan and the processing, which, for example, is taken into account by a prioritization algorithm to provide the dynamic distributing of the processing of the scan data among the processing participants 100, 101, 102.

The cloud processing unit 101 has knowledge on current bandwidth of connection speed to the one or the plurality of surveying devices 100 and to the one or the plurality of client devices 102. For example, it further receives scan and processing predictions and local information on current scan and calculation conditions from each of the surveying devices 100. Similarly, it may receive local information from each of the client devices 102. By way of example, the cloud processing unit 101 is able to provide an overall calculation/estimate of the required processing in order to provide a minimum content amount to display a preview on a user device, e.g. one of the client devices 102. Given the large computing power of a cloud processing unit compared to the surveying devices and the client devices, the cloud processing unit 100 may be the central computing unit to gather all available information and to predict a time to process and to stream, as well as to provide the final distribution decision for the dynamic distribution of the processing of the scan data among the processing participants 100, 101, 102.

By way of example, as the dynamic distribution of the processing of the scan data is a n-to-n issue, consensual decisions are used. The normal decision may be a straight forward linear optimization. However, based on experience (i.e. average duration vs. predicted, average failure rate of a scan, does the battery even work long enough, ... ) this decision can be altered.

The invention provides an optimized processing pipeline from reality to screen, with the least failures at the highest throughput. For example, the system provides improved decision on feasibility of the overall computation, an improved assignment on who is computing, and a local (one process chain) and global (multiple processing and intersecting chains) optimization.

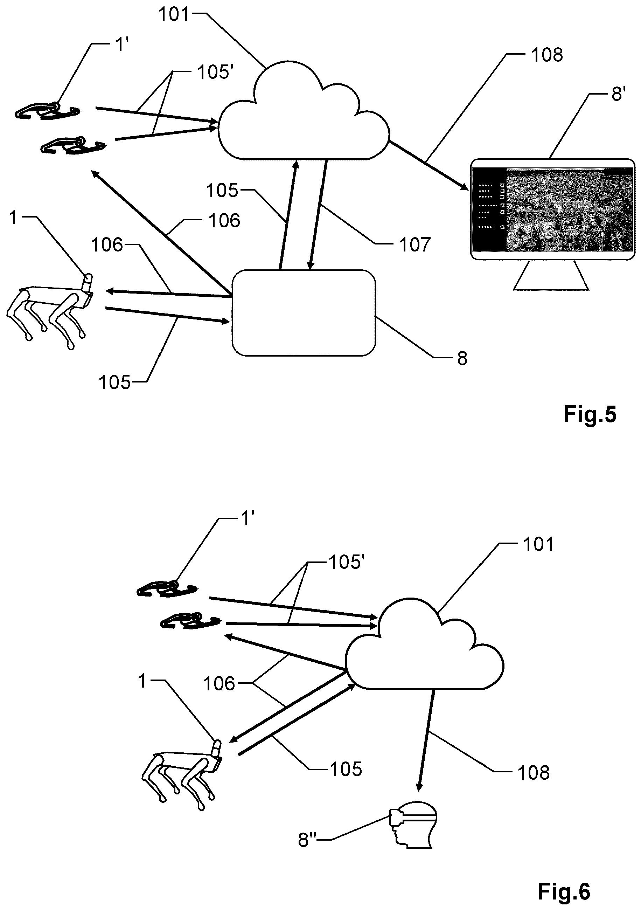

**Figures 5 to 7** schematically depict different processing situations with varying prioritization among the processing participants due to external influences.

**Figure 5** refers to a situation with overall high available bandwidths between the processing participants. Spatial scan data 105 from a surveying device 1 arranged on a ground-based robot are communicated to a companion device 8, e.g. a tablet to be used for controlling the surveying device 1 and/or the ground-based robot. The companion device 8 forwards the scan data 105, e.g. in the form of raw scan data as well as partly processed scan data, to a cloud processing unit 101, which uses the provided scan data to provide the companion device 8 with advanced processing results 107. The companion device 8 then uses these advanced processing results 107 to calculate trajectory information 106, which is provided to the surveying device 1 and the ground-based robot as well as to aerial surveying devices 1' and their aerial carriers. The aerial surveying devices 1' provide their scan data 105' to the cloud processing unit 101, wherein the scan data 105' of the aerial surveying devices 1' may be used by the cloud processing unit 101 to provide the advanced processing results 107. Finally, the cloud processing unit 101 provides minimal processing units 108 to a further client device 8', e.g. a personal computer, in order to provide a user with a preview of the measurement results and the current scan process.

**Figure 6** refers to a situation wherein the surveying devices 1, 1' and a client device 8", e.g. augmented reality glasses, have only limited computing power and reduced battery charging, wherein fast connectivity to the cloud processing unit 101 is available. Thus, the scan data 105, 105' from the surveying devices 1, 1' are directly provided to the cloud processing unit 101, which carries out the main processing load to provide trajectory information 106 to the surveying devices 1, 1' and to provide the minimal processing units 108 to the client device 8" in order to show the user a preview of the measurement results and the current scan process.

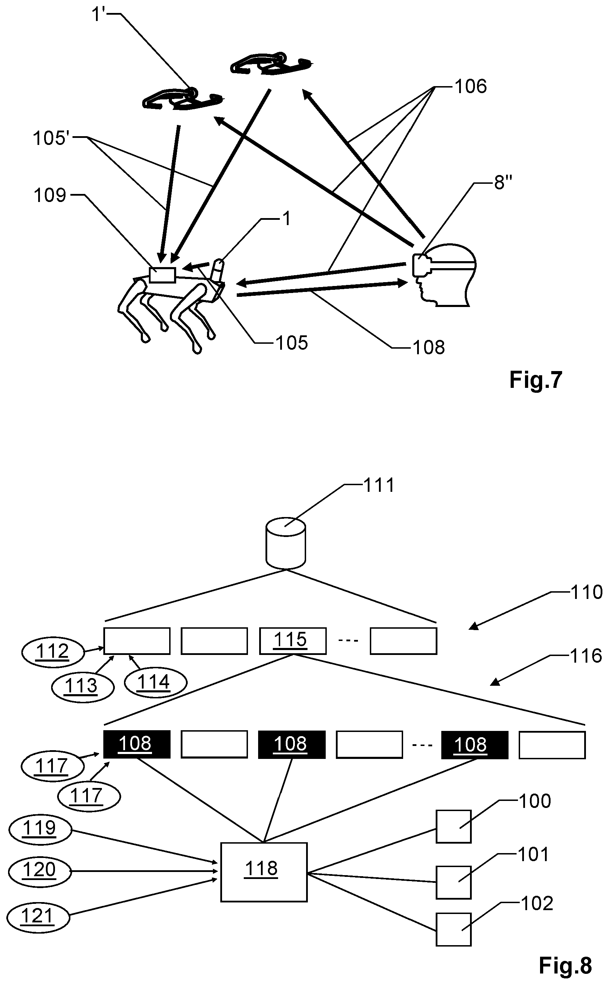

**Figure 7** refers to a situation with limited connectivity to the cloud. Thus, processing is mainly carried out locally, e.g. on a computing unit 109 of the ground-based robot, which is provided with the spatial scan data 105, 105' of the surveying device 1 located on the ground-based robot and the aerial surveying devices 1". Here, trajectory information 106 for both the surveying device 1 on the ground and the aerial surveying devices 1' is provided by the user by means of a manual input functionality provided by augmented reality glasses. The computing unit 109 of the ground-based robot provides the minimal processing units 108 to the client device 8" in order to show the user a preview of the measurement results and the current scan process. Alternatively, the surveying devices 1, 1' themselves might be configured to provide the main processing to determine the minimal processing units 108. However, computation and battery power of the surveying devices 1, 1' is often limited.

**Figure 8** schematically depicts a workflow to determine the minimal processing units 108 and to distribute the minimal processing units among the processing participants 100, 101, 102.

By way of example, a plurality of workflows 110 are stored on a workflow database 111. Each workflow 110 is associated with a data format 112, acquisition parameters 113, and a target format 114 of a digital model to be provided by the workflow 110, wherein the target format of the digital model defines visualization criteria for a display of a preview of the digital model. The system automatically recognizes a current workflow 115 to be executed out of the stored workflows 110. For example, in order to recognize the current workflow 115 the system is configured to analyze a trajectory behavior of involved surveying devices as well as a recent history of operating settings of the surveying devices.

Each workflow 110 is associated with multiple fragmentation options to split the processing of the scan data into fragments 116 to provide processing of scan data on different processing units, wherein the sum of the fragments 116 provides the digital model associated with the recognized current workflow 115. The fragments are associated with processing costs 117 that, for example, provide information on computation requirements, processing time, power consumption, and data exchange needs.

Among the fragments 116, the system automatically derives minimal processing units 108 to provide the display of the representation of the preview of the digital model in a way that it fulfils the visualization criteria associated to the current workflow 115.

By using a prioritization unit 118, the processing costs 117 for the minimal processing units 108 are then compared to currently available connection 119, processing 120, and power 121 conditions associated with the processing participants in order to provide an optimized distribution of the minimal processing units 108 among the processing participants, i.e. the surveying devices 100, client devices 102, and a cloud processing unit 101, which minimizes processing time to display the preview.

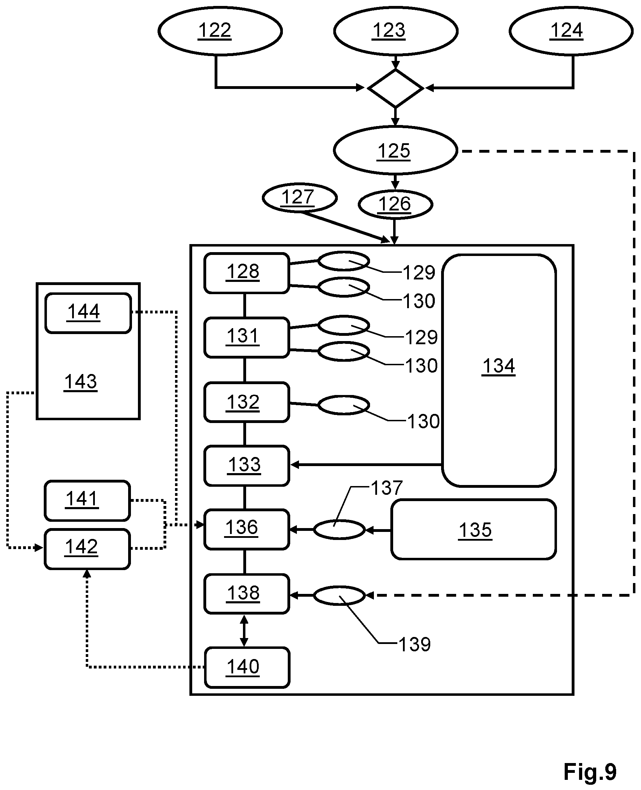

**Figure 9** schematically depicts a decision making process within a further embodiment of the invention. The prioritization algorithm can be tuned towards different main settings, e.g. a setting 122 providing minimum time from the scan to visualization of the preview (e.g. accepting a currently available data quality and thus accepting an "intrinsic" visualization quality), a setting 123 providing a defined (limited) quality with reasonable battery impact (e.g. to provide a visualization "as quick as practical"), and a setting 124 providing maximum battery usage for longest in-field scanning.

For example, the user of the 3D surveying device selects a desired setting 125 out of the available main settings 122, 123, 124 via a user interface on the 3D surveying device or on a connected companion device, e.g. a tablet in wireless connection with the surveying device. A query for defining the main setting may be triggered at each start of a new measurement process by the surveying device or only upon manual triggering by a user, e.g. wherein a previous setting associated with the surveying device is stored or wherein a global setting is pre-set for a set of surveying devices.

The selection of the desired setting 125 then defines an optimization target 126 of the optimization by the prioritization algorithm. For example, the selection of a main setting 125 causes an automatic prioritization of certain visualization criteria in the step of associating the model type to visualization criteria for the display of a representation of the preview of the digital model. Alternatively or in addition, the selection of the desired setting 125 defines a certain weighting of different target values of the prioritization algorithm with respect to each other. For example, a stronger weight is given to the target value "long battery power on the 3D surveying device" relative to the weight of the target value "short time to provide the minimum processing units", e.g. wherein more weight on the target value "long battery power" forces a reduction of local computation on the 3D surveying device.

In addition, there may be an option 127 to request or propose a specific workflow, e.g. in terms of processing participants and a type of the digital model to be provided.

Having the optimization target 126 in hand, on-device processing capabilities 128 (processing capabilities on the 3D surveying device) are queried, e.g. available battery power 129 and availability for processing 130. Similarly, processing capabilities nearby 131 and processing capabilities in the cloud 132 are queried. For example, these queries check for available battery power 129 of a client device and availability to take over parts of the processing 130 by a client device and the cloud, respectively.

In a next step 133, the requested workflow 127 is compared to different workflow specifications stored in a workflow database, e.g. to check whether the requested workflow is suitable under current conditions or needs to be adapted. By way of example, criteria 134 to be considered are availably device types, e.g. in terms of scanning functionality, battery specification, and computing capability, number of available surveying devices, and trajectory and 3D scan options.

Having a confirmed or updated workflow in hand, stored optimization parameters 135 are used in a next step 136 to optimize and verify feasibility of the confirmed or update workflow, e.g. wherein optimization parameters such as point density, image quality, measurement accuracy, temperature, measurement time, and bandwidth optimization are used to derive an optimization goal 137. After the optimization and verifying of the feasibility, the workflow is set up and executed 138. By way of example, this step further requires the user to review the derived settings and specifications and to provide feedback 139, e.g. to confirm or reject his initial selection of the main settings 122, 123, 124.

The results of the workflow and information of the conditions under which the workflow was defined and executed may further be stored 140 in a benchmark database, e.g. to be used for linear optimization 141 and/or for multi-objective optimization 142.

For example, multi-object optimization 142 involves using of a benchmark device 143 for executing workflow steps, e.g. wherein benchmark processing steps 144 are defined for determining benchmark data exchange variants, wherein the results are registered in the workflow database.

## Claims

1. Method for providing a digital model of an environment based on scan data (105, 105') provided by a 3D surveying device (1, 1', 1", 100), wherein the scan data provide spatial 3D information of the environment, wherein the method comprises
• deriving a scan task to be currently executed by the 3D surveying device (1, 1', 1", 100) and an associated model type of the digital model to be provided,
• associating the model type to visualization criteria (122-125) for a display of a representation of a preview of the digital model,
• deriving minimal processing units (108) for processing the scan data (105, 105') to provide the display of the representation of the preview of the digital model in a way that it fulfils the visualization criteria (122-125), and
• using a prioritization algorithm (118) to dynamically distribute different processing assignments for processing the scan data (105, 105') among processing participants (1, 1', 1", 100, 101, 8, 8', 8", 102, 109), wherein the prioritization algorithm is configured to provide an optimization (126) in terms of definition and distribution of the different processing assignments with a short time to provide the minimal processing units (108) as a target value and with a currently available bandwidth (119) and connection stability (119) of a data exchange between the processing participants with one another, a currently available computing power (120, 130, 131, 132) on each of the processing participants, and remaining battery power (121, 129) on the 3D surveying device (1, 1', 1", 100) as input parameters,
· distributing processing of the scan data (105, 105') among a group of processing participants comprising the 3D surveying device (1, 1', 1", 100), a cloud processing unit (101), and a client device (8, 8', 8", 102, 109), and causing the processing participants to execute different processing steps to provide the digital model,
. displaying a representation of the digital model.

2. Method according to claim 1, wherein the scan task and/or the associated model type is/are derived by user input.

3. Method according to one of the preceding claims, wherein the scan task is determined by analyzing a motion state history and/or an operation history of the 3D surveying device (1, 1', 1", 100) to provide an estimate of a further motion state and/or operating condition of the 3D surveying device.

4. Method according to one of the preceding claims, wherein the associating of the model type to the visualization criteria comprises a selecting between
• visualization criteria (122, 125) providing a reachable quality of the display of the representation of the preview of the digital model on the basis of a currently available data quality of the scan data (105, 105'), and
• visualization criteria (123, 125) providing a defined target quality of the display of the representation of the preview of the digital model, particularly wherein the defined target quality is a maximally reachable target quality in a defined time window.

5. Method according to one of the preceding claims, wherein the optimization (126) comprises a long battery power on the 3D surveying device (1, 1', 1", 100) as further target value (124, 125), and the prioritization algorithm is configured to provide an adjustment option to adjust a weighting of the target value relative to the further target value, particularly wherein more weight on the further target value causes a reduction of local computation on the 3D surveying device (1, 1', 1", 100).

6. Method according to one of the preceding claims, wherein the input parameters further comprise an internal temperature parameter of the 3D surveying device (1, 1', 1", 100), particularly a heat gradient within the 3D surveying device determined each ten seconds,
particularly wherein the prioritization algorithm is configured to take into account the internal temperature parameter to estimate the remaining battery power (121, 129) on the 3D surveying device (1, 1', 1", 100).

7. Method according to one of the preceding claims, comprising a deriving of a history of a battery life (121) as a function of on-device computation load of at least one of the 3D surveying device (1, 1', 1", 100) and the client device (8, 8', 8", 102, 109), wherein the optimization (126) takes into account the history of the battery life as a function of on-device computation load, particularly by means of a consensual decision rule.

8. Method according to one of the preceding claims, comprising a deriving of a recommendation by the 3D surveying device (1, 1', 1", 100) with regard to definition and/or distribution of the different processing assignments, wherein the prioritization algorithm (118) is configured to take into account the recommendation by the 3D surveying device for providing the definition and distribution of the different processing assignments.

9. Method according to claim 8, wherein the recommendation by the 3D surveying device (1, 1', 1", 100) is triggered by a change in an operating condition of the 3D surveying device.

10. Method according to one of the preceding claims, comprising a deriving of a recommendation by the client device (8, 8', 8", 102, 109) with regard to available processing by the client device, wherein the prioritization algorithm is configured to take into account the recommendation by the client device for providing the definition and distribution of the different processing assignments,
particularly wherein the recommendation by the client device is triggered by a change in an operating condition of the client device.

11. Method according to one of the preceding claims, wherein the deriving of the scan task and the associating of the model type to the visualization criteria (122-125) are executed by a comparison of the scan data with a plurality of workflows (110, 115) stored on a workflow database (111), wherein each workflow (110) is defined by a data format (112) and/or an acquisition parameter (113) of the scan data and a target format (114) of the digital model.

12. Method according to claim 11, wherein each workflow is associated with multiple fragmentation options to split the processing of the scan data (105, 105') into fragments (116) to provide the target format of the digital model, wherein each fragment is associated with processing costs (117) that provide information on computation requirements, processing time, power consumption, and data exchange needs, wherein the prioritization algorithm (118) is configured to carry out a comparison of the processing costs of the fragments with the currently available bandwidth (119) and connection stability (119) of the data exchange between the processing participants with one another, the currently available computing power (120, 130, 131, 132) on each of the processing participants, and the remaining battery power (121, 129) on the 3D surveying device (1, 1', 1", 100) and the client device (8, 8', 8", 102, 109), and to calculate a processing time to provide the minimal processing units (108) with different permutations of the multiple fragmentation options.

13. Surveying system, configured for carrying out the method according to one of claims 1 to 12, for which the system comprises
• a 3D surveying device (1, 1', 1", 100) configured to provide the scan data (105, 105') of the step of distributing processing of the scan data among a group of processing participants according to claim 1, and
• a cloud processing unit (101) and a client device (8, 8', 8", 102, 109), wherein the 3D surveying device, the cloud processing unit, and the client device are part of the group of processing participants of the step of distributing processing of the scan data among a group of processing participants according to claim 1.

14. System according to claim 13, wherein the system further comprises a user interface configured to provide an input functionality for the step of selecting according to claim 4, and/or for providing a weighting change to be used by the adjustment option according to claim 5.

15. Computer program product comprising program code stored on a machine-readable medium or being embodied by an electromagnetic wave comprising a program code segment, wherein the program code comprises a prioritization algorithm (118) configured to provide definition of different processing assignments for processing scan data (105, 105') of a 3D surveying device (1, 1', 1", 100) and distribution of the different processing assignments among processing participants comprising the 3D surveying device (1, 1', 1", 100), a cloud processing unit (101), and a client device (8, 8', 8", 102, 109), wherein the program code further comprises computer-executable instructions for performing,
• deriving a scan task to be currently executed by the 3D surveying device (1, 1', 1", 100) and an associated model type of a digital model of an environment to be provided by the scan data (105, 105'),
• associating the model type to visualization criteria (122-125) for a display of a representation of a preview of the digital model,
• deriving minimal processing units (108) for processing the scan data (105, 105') to provide the display of the representation of the preview of the digital model in a way that it fulfils the visualization criteria (122-125), and
• using the prioritization algorithm (118) to provide dynamic distribution of the different processing assignments among the processing participants, wherein the prioritization algorithm (118) is configured to provide an optimization (126) in terms of definition and distribution of the different processing assignments with a short time to provide the minimal processing units as a target value and with a currently available bandwidth (119) and connection stability (119) of a data exchange between the processing participants with one another, a currently available computing power (120, 130, 131, 132) on each of the processing participants, and remaining battery power (121, 129) on the 3D surveying device (1, 1', 1", 100) as input parameters.

## Patentansprüche

1. Verfahren zum Bereitstellen eines digitalen Modells einer Umgebung basierend auf von einer 3D-Vermessungsvorrichtung (1, 1', 1", 100) bereitgestellten Scandaten (105, 105'), wobei die Scandaten räumliche 3D-Informationen der Umgebung bereitstellen, wobei das Verfahren umfasst
• Ableiten einer Scanaufgabe, die von der 3D-Vermessungsvorrichtung (1, 1', 1", 100) gegenwärtig ausgeführt werden soll, und eines zugehörigen Modelltyps des bereitzustellenden digitalen Modells,
• Zuordnen des Modelltyps zu Visualisierungskriterien (122-125) für eine Anzeige einer Darstellung einer Vorschau des digitalen Modells,
• Ableiten minimaler Verarbeitungseinheiten (108) zum Verarbeiten der Scandaten (105, 105'), um die Anzeige der Darstellung der Vorschau des digitalen Modells derart bereitzustellen, dass sie die Visualisierungskriterien (122-125) erfüllt, und
• Verwenden eines Priorisierungsalgorithmus (118), um verschiedene Verarbeitungszuweisungen für das Verarbeiten der Scandaten (105, 105') unter den Verarbeitungsteilnehmern ((1, 1', 1", 100, 101, 8, 8', 8", 102, 109) dynamisch zu verteilen, wobei der Priorisierungsalgorithmus eingerichtet ist, eine Optimierung (126) hinsichtlich der Definition und Verteilung der verschiedenen Verarbeitungszuweisungen mit einer kurzen Zeit bereitzustellen, um die minimalen Verarbeitungseinheiten (108) als ein Zielwert und mit einer gegenwärtig verfügbaren Bandbreite (119) und Verbindungsstabilität (119) eines Datenaustauschs zwischen den Verarbeitungsteilnehmern untereinander, einer aktuell verfügbaren Rechenleistung (120, 130, 131, 132) auf jedem der Verarbeitungsteilnehmer und der verbleibenden Batterieleistung (121, 129) auf der 3D-Vermessungsvorrichtung (1, 1', 1", 100) als Eingabeparameter bereitzustellen,
• Verteilen der Verarbeitung der Scandaten (105, 105') unter einer Gruppe von Verarbeitungsteilnehmern, welche die 3D-Vermessungsvorrichtung (1, 1', 1", 100), eine Cloud-Verarbeitungseinheit (101) und eine Client-Vorrichtung (8, 8', 8", 102, 109) umfasst, und Veranlassen der Verarbeitungsteilnehmer, verschiedene Verarbeitungsschritte auszuführen, um das digitale Modell bereitzustellen,
• Anzeigen einer Darstellung des digitalen Modells.

2. Verfahren nach Anspruch 1, wobei die Scanaufgabe und/oder der zugehörige Modelltyp durch eine Benutzereingabe abgeleitet werden.

3. Verfahren nach einem der vorstehenden Ansprüche, wobei die Scanaufgabe durch Analysieren eines Bewegungsstatusverlaufs und/oder eines Betriebsverlaufs der 3D-Vermessungsvorrichtung (1, 1', 1", 100) bestimmt wird, um eine Schätzung eines weiteren Bewegungsstatus und/oder Betriebszustands der 3D-Vermessungsvorrichtung bereitzustellen.

4. Verfahren nach einem der vorstehenden Ansprüche, wobei das Zuordnen des Modelltyps zu den Visualisierungskriterien ein Auswählen umfasst zwischen
• Visualisierungskriterien (122, 125), die eine erreichbare Qualität der Anzeige der Darstellung der Vorschau des digitalen Modells basierend auf einer gegenwärtig verfügbaren Datenqualität der Scandaten (105, 105') bereitstellen, und
• Visualisierungskriterien (123, 125), die eine definierte Zielqualität der Anzeige der Darstellung der Vorschau des digitalen Modells bereitstellen, wobei insbesondere die definierte Zielqualität eine maximal erreichbare Zielqualität in einem definierten Zeitfenster ist.

5. Verfahren nach einem der vorstehenden Ansprüche, wobei die Optimierung (126) eine lange Batterieleistung auf der 3D-Vermessungsvorrichtung (1, 1', 1", 100) als weiteren Zielwert (124, 125) umfasst und der Priorisierungsalgorithmus eingerichtet ist, eine Anpassungsoption bereitzustellen, um eine Gewichtung des Zielwerts relativ zu dem weiteren Zielwert anzupassen, wobei insbesondere mehr Gewicht auf dem weiteren Zielwert eine Reduzierung der lokalen Berechnung auf der 3D-Vermessungsvorrichtung (1, 1', 1", 100) bewirkt.

6. Verfahren nach einem der vorstehenden Ansprüche, wobei die Eingabeparameter ferner einen internen Temperaturparameter der 3D-Vermessungsvorrichtung (1, 1', 1", 100) und insbesondere einen alle zehn Sekunden bestimmten Wärmegradienten innerhalb der 3D-Vermessungsvorrichtung umfassen,
wobei insbesondere der Priorisierungsalgorithmus eingerichtet ist, den internen Temperaturparameter zu berücksichtigen, um die verbleibende Batterieleistung (121, 129) auf der 3D-Vermessungsvorrichtung (1, 1', 1", 100) zu schätzen.

7. Verfahren nach einem der vorstehenden Ansprüche, umfassend ein Ableiten eines Verlaufs einer Batterielebensdauer (121) als Funktion der Rechenlast auf der Vorrichtung von mindestens einer von der 3D-Vermessungsvorrichtung (1, 1', 1", 100) und der Client-Vorrichtung (8, 8', 8", 102, 109), wobei die Optimierung (126) den Verlauf der Batterielebensdauer als Funktion der Rechenlast auf der Vorrichtung insbesondere mittels einer einvernehmlichen Entscheidungsregel berücksichtigt.

8. Verfahren nach einem der vorstehenden Ansprüche, umfassend ein Ableiten einer Empfehlung durch die 3D-Vermessungsvorrichtung (1, 1', 1", 100) hinsichtlich der Definition und/oder Verteilung der verschiedenen Verarbeitungszuweisungen,
wobei der Priorisierungsalgorithmus (118) eingerichtet ist, die Empfehlung durch die 3D-Vermessungsvorrichtung zum Bereitstellen der Definition und Verteilung der verschiedenen Verarbeitungszuweisungen zu berücksichtigen.

9. Verfahren nach Anspruch 8, wobei die Empfehlung durch die 3D-Vermessungsvorrichtung (1, 1', 1", 100) durch eine Änderung in einem Betriebszustand der 3D-Vermessungsvorrichtung ausgelöst wird.

10. Verfahren nach einem der vorstehenden Ansprüche, umfassend ein Ableiten einer Empfehlung durch die Client-Vorrichtung (8, 8', 8", 102, 109) hinsichtlich der verfügbaren Verarbeitung durch die Client-Vorrichtung, wobei der Priorisierungsalgorithmus eingerichtet ist, die Empfehlung der Client-Vorrichtung zum Bereitstellen der Definition und Verteilung der verschiedenen Verarbeitungszuweisungen zu berücksichtigen,
wobei die Empfehlung durch die Client-Vorrichtung insbesondere durch eine Änderung in einem Betriebszustand der Client-Vorrichtung ausgelöst wird.

11. Verfahren nach einem der vorstehenden Ansprüche, wobei das Ableiten der Scanaufgabe und das Zuordnen des Modelltyps zu den Visualisierungskriterien (122-125) durch einen Vergleich der Scandaten mit mehreren in einer Workflow-Datenbank (111) gespeicherten Workflows (110, 115) durchgeführt werden, wobei jeder Workflow (110) durch ein Datenformat (112) und/oder einen Erfassungsparameter (113) der Scandaten und ein Zielformat (114) des digitalen Modells definiert ist.

12. Verfahren nach Anspruch 11, wobei jeder Workflow mehreren Fragmentierungsoptionen zugeordnet ist, um die Verarbeitung der Scandaten (105, 105') in Fragmente (116) aufzuteilen und das Zielformat des digitalen Modells bereitzustellen, wobei jedes Fragment mit Verarbeitungskosten (117) in Zusammenhang steht, die Informationen über Rechenanforderungen, Verarbeitungszeit, Stromverbrauch und Datenaustauschanforderungen bereitstellen, wobei der Priorisierungsalgorithmus (118) eingerichtet ist, einen Vergleich der Verarbeitungskosten der Fragmente mit der gegenwärtig verfügbaren Bandbreite (119) und Verbindungsstabilität (119) des Datenaustauschs zwischen den Verarbeitungsteilnehmern untereinander, der gegenwärtig verfügbaren Rechenleistung (120, 130, 131, 132) auf jedem der Verarbeitungsteilnehmer und der verbleibenden Batterieleistung (121, 129) auf der 3D-Vermessungsvorrichtung (1, 1', 1", 100) und der Client-Vorrichtung (8, 8', 8", 102, 109) auszuführen und eine Verarbeitungszeit zu berechnen, um die minimalen Verarbeitungseinheiten (108) mit verschiedenen Permutationen der mehreren Fragmentierungsoptionen bereitzustellen.

13. Vermessungssystem, das zum Ausführen des Verfahrens nach einem der Ansprüche 1 bis 12 eingerichtet ist, wobei das System umfasst
• eine 3D-Vermessungsvorrichtung (1, 1', 1", 100), die eingerichtet ist, die Scandaten (105, 105') des Schritts des Verteilens der Verarbeitung der Scandaten unter einer Gruppe von Verarbeitungsteilnehmern nach Anspruch 1 bereitzustellen, und
• eine Cloud-Verarbeitungseinheit (101) und eine Client-Vorrichtung (8, 8', 8", 102, 109),
wobei die 3D-Vermessungsvorrichtung, die Cloud-Verarbeitungseinheit und die Client-Vorrichtung Teil der Gruppe von Verarbeitungsteilnehmern des Schritts des Verteilens der Verarbeitung der Scandaten unter einer Gruppe von Verarbeitungsteilnehmern nach Anspruch 1 sind.

14. System nach Anspruch 13, wobei das System ferner eine Benutzerschnittstelle umfasst, die eingerichtet ist, eine Eingabefunktionalität für den Schritt des Auswählens nach Anspruch 4 bereitzustellen, und/oder zum Bereitstellen einer Gewichtungsänderung, die von der Anpassungsoption nach Anspruch 5 zu verwenden ist.

15. Computerprogrammprodukt, das einen Programmcode umfasst, der auf einem maschinenlesbaren Medium gespeichert ist oder durch eine elektromagnetische Welle verkörpert ist, die ein Programmcodesegment umfasst, wobei der Programmcode einen Priorisierungsalgorithmus (118) umfasst, der eingerichtet ist, eine Definition verschiedener Verarbeitungszuweisungen für die Verarbeitung der Scandaten (105, 105') einer 3D-Vermessungsvorrichtung (1, 1', 1", 100) und die Verteilung der verschiedenen Verarbeitungszuweisungen unter den Verarbeitungsteilnehmern bereitzustellen, welche die 3D-Vermessungsvorrichtung (1, 1', 1", 100), eine Cloud-Verarbeitungseinheit (101) und eine Client-Vorrichtung (8, 8', 8", 102, 109) umfassen, wobei der Programmcode ferner computerausführbare Anweisungen umfasst zum Ausführen von
• Ableiten einer Scanaufgabe, die gegenwärtig von der 3D-Vermessungsvorrichtung (1, 1', 1", 100) ausgeführt werden soll, und eines zugehörigen Modelltyps eines durch die Scandaten (105, 105') bereitzustellenden digitalen Modells einer Umgebung,
• Zuordnen des Modelltyps zu Visualisierungskriterien (122-125) für eine Anzeige einer Darstellung einer Vorschau des digitalen Modells,
• Ableiten minimaler Verarbeitungseinheiten (108) zum Verarbeiten der Scandaten (105, 105'), um die Anzeige der Darstellung der Vorschau des digitalen Modells derart bereitzustellen, dass sie die Visualisierungskriterien (122-125) erfüllt, und
• Verwenden des Priorisierungsalgorithmus (118), um eine dynamische Verteilung der verschiedenen Verarbeitungszuweisungen unter den Verarbeitungsteilnehmern bereitzustellen,
wobei der Priorisierungsalgorithmus (118) eingerichtet ist, eine Optimierung (126) hinsichtlich der Definition und Verteilung der verschiedenen Verarbeitungszuweisungen mit einer kurzen Zeit bereitzustellen, um die minimalen Verarbeitungseinheiten als Zielwert und mit einer gegenwärtig verfügbaren Bandbreite (119) und Verbindungsstabilität (119) eines Datenaustauschs zwischen den Verarbeitungsteilnehmern untereinander, einer gegenwärtig verfügbaren Rechenleistung (120, 130, 131, 132) auf jedem der Verarbeitungsteilnehmer und der verbleibenden Batterieleistung (121, 129) auf der 3D-Vermessungsvorrichtung (1, 1', 1", 100) als Eingabeparameter bereitzustellen.

## Revendications

1. Procédé pour fournir un modèle numérique d'un environnement basé sur des données de balayage (105, 105') fournies par un dispositif d'arpentage 3D (1, 1', 1", 100), dans lequel les données de balayage fournissent des informations 3D spatiales de l'environnement, le procédé comprenant les étapes consistant à :
• dériver une tâche de balayage à exécuter actuellement par le dispositif d'arpentage 3D (1, 1', 1", 100) et un type de modèle associé du modèle numérique à fournir,
• associer le type de modèle à des critères de visualisation (122-125) pour un affichage d'une représentation d'un aperçu du modèle numérique,
• dériver des unités de traitement minimales (108) pour traiter les données de balayage (105, 105') afin de fournir l'affichage de la représentation de l'aperçu du modèle numérique de manière à ce qu'il réponde aux critères de visualisation (122-125), et
• utiliser un algorithme de priorisation (118) pour répartir de manière dynamique différentes affectations de traitement pour traiter les données de balayage (105, 105') parmi les participants au traitement (1, 1', 1", 100, 101, 8, 8', 8", 102, 109), dans lequel l'algorithme de priorisation est configuré pour fournir une optimisation (126) en termes de définition et de répartition des différentes affectations de traitement avec un temps court pour fournir les unités de traitement minimales (108) comme valeur cible et avec une bande passante actuellement disponible (119) et une stabilité de connexion (119) d'un échange de données entre les participants au traitement les uns avec les autres, une puissance de calcul actuellement disponible (120, 130, 131, 132) sur chacun des participants au traitement et une énergie de batterie restante (121, 129) sur le dispositif d'arpentage 3D (1, 1', 1", 100) comme paramètres d'entrée,
• répartir le traitement des données de balayage (105, 105') entre un groupe de participants au traitement comprenant le dispositif d'arpentage 3D (1, 1', 1", 100), une unité de traitement en nuage (101) et un dispositif client (8, 8', 8", 102, 109), et amener les participants au traitement à exécuter différentes étapes de traitement pour fournir le modèle numérique,
• afficher une représentation du modèle numérique.

2. Procédé selon la revendication 1, dans lequel la tâche de balayage et/ou le type de modèle associé sont dérivés d'une entrée de l'utilisateur.

3. Procédé selon l'une des revendications précédentes, dans lequel la tâche de balayage est déterminée en analysant un historique d'état de mouvement et/ou un historique de fonctionnement du dispositif d'arpentage 3D (1, 1', 1", 100) afin de fournir une estimation d'un état de mouvement et/ou d'une condition de fonctionnement ultérieurs du dispositif d'arpentage 3D.

4. Procédé selon l'une des revendications précédentes, dans lequel l'association du type de modèle aux critères de visualisation comprend une sélection entre
• des critères de visualisation (122, 125) fournissant une qualité atteignable de l'affichage de la représentation de l'aperçu du modèle numérique sur la base d'une qualité de données actuellement disponible des données de balayage (105, 105'), et
• des critères de visualisation (123, 125) fournissant une qualité cible définie de l'affichage de la représentation de l'aperçu du modèle numérique, en particulier dans lequel la qualité cible définie est une qualité cible maximale atteignable dans une fenêtre temporelle définie.

5. Procédé selon l'une des revendications précédentes, dans lequel l'optimisation (126) comprend une longue énergie de batterie sur le dispositif d'arpentage 3D (1, 1', 1", 100) comme valeur cible supplémentaire (124, 125), et l'algorithme de priorisation est configuré pour fournir une option d'ajustement afin d'ajuster une pondération de la valeur cible par rapport à l'autre valeur cible, en particulier dans lequel une pondération plus importante de l'autre valeur cible entraîne une réduction du calcul local sur le dispositif d'arpentage 3D (1, 1', 1", 100).

6. Procédé selon l'une des revendications précédentes, dans lequel les paramètres d'entrée comprennent en outre un paramètre de température interne du dispositif d'arpentage 3D (1, 1', 1", 100), en particulier un gradient thermique à l'intérieur du dispositif d'arpentage 3D déterminé toutes les dix secondes,
en particulier dans lequel l'algorithme de priorisation est configuré pour prendre en compte le paramètre de température interne afin d'estimer l'énergie de batterie restante (121, 129) sur le dispositif d'arpentage 3D (1, 1', 1", 100).

7. Procédé selon l'une des revendications précédentes, comprenant une dérivation d'un historique d'une durée de vie de batterie (121) en fonction d'une charge de calcul du dispositif d'au moins l'un parmi le dispositif d'arpentage 3D (1, 1', 1", 100) et le dispositif client (8, 8', 8", 102, 109), dans lequel l'optimisation (126) prend en compte l'historique de la durée de vie de batterie en fonction de la charge de calcul du dispositif, en particulier au moyen d'une règle de décision consensuelle.

8. Procédé selon l'une des revendications précédentes, comprenant une dérivation d'une recommandation par le dispositif d'arpentage 3D (1, 1', 1", 100) en ce qui concerne la définition et/ou la répartition des différentes affectations de traitement, dans lequel l'algorithme de priorisation (118) est configuré pour prendre en compte la recommandation par le dispositif d'arpentage 3D afin de fournir la définition et la répartition des différentes affectations de traitement.

9. Procédé selon la revendication 8, dans lequel la recommandation par le dispositif d'arpentage 3D (1, 1', 1", 100) est déclenchée par un changement dans une condition de fonctionnement du dispositif d'arpentage 3D.

10. Procédé selon l'une des revendications précédentes, comprenant une dérivation d'une recommandation par le dispositif client (8, 8', 8", 102, 109) en ce qui concerne le traitement disponible par le dispositif client, dans lequel l'algorithme de priorisation est configuré pour prendre en compte la recommandation par le dispositif client afin de fournir la définition et la répartition des différentes affectations de traitement,
en particulier dans lequel la recommandation par le dispositif client est déclenchée par un changement dans une condition de fonctionnement du dispositif client.

11. Procédé selon l'une des revendications précédentes, dans lequel la dérivation de la tâche de balayage et l'association du type de modèle aux critères de visualisation (122-125) sont exécutées par une comparaison des données de balayage avec une pluralité de flux de travail (110, 115) stockés dans une base de données de flux de travail (111), dans lequel chaque flux de travail (110) est défini par un format de données (112) et/ou un paramètre d'acquisition (113) des données de balayage et un format cible (114) du modèle numérique.

12. Procédé selon la revendication 11, dans lequel chaque flux de travail est associé à de multiples options de fragmentation pour diviser le traitement des données de balayage (105, 105') en fragments (116) afin de fournir le format cible du modèle numérique, dans lequel chaque fragment est associé à des coûts de traitement (117) qui fournissent des informations sur les exigences de calcul, le temps de traitement, la consommation d'énergie et les besoins en échange de données, dans lequel l'algorithme de priorisation (118) est configuré pour effectuer une comparaison des coûts de traitement des fragments avec la bande passante actuellement disponible (119) et la stabilité de connexion (119) de l'échange de données entre les participants au traitement les uns avec les autres, la puissance de calcul actuellement disponible (120, 130, 131, 132) sur chacun des participants au traitement, et l'énergie de batterie restante (121, 129) du dispositif d'arpentage 3D (1, 1', 1", 100) et du dispositif client (8, 8', 8", 102, 109), et pour calculer un temps de traitement afin de fournir les unités de traitement minimales (108) avec différentes permutations des multiples options de fragmentation.

13. Système d'arpentage, configuré pour mettre en œuvre le procédé selon l'une des revendications 1 à 12, ce pour quoi le système comprend :
• un dispositif d'arpentage 3D (1, 1', 1", 100) configuré pour fournir les données de balayage (105, 105') de l'étape consistant à répartir le traitement des données de balayage entre un groupe de participants au traitement selon la revendication 1, et
• une unité de traitement en nuage (101) et un dispositif client (8, 8', 8", 102, 109),
dans lequel le dispositif d'arpentage 3D, l'unité de traitement en nuage et le dispositif client font partie du groupe de participants au traitement de l'étape consistant à répartir le traitement des données de balayage entre un groupe de participants au traitement selon la revendication 1.

14. Système selon la revendication 13, dans lequel le système comprend en outre une interface utilisateur configurée pour fournir une fonctionnalité d'entrée pour l'étape de sélection selon la revendication 4, et/ou pour fournir un changement de pondération à utiliser par l'option d'ajustement selon la revendication 5.

15. Produit logiciel comprenant un code de programme stocké sur un support lisible par machine ou matérialisé par une onde électromagnétique comprenant un segment de code de programme, dans lequel le code de programme comprend un algorithme de priorisation (118) configuré pour fournir une définition de différentes affectations de traitement pour le traitement de données de balayage (105, 105') d'un dispositif d'arpentage 3D (1, 1', 1", 100) et la répartition des différentes affectations de traitement entre les participants au traitement comprenant le dispositif d'arpentage 3D (1, 1', 1", 100), une unité de traitement en nuage (101) et un dispositif client (8, 8', 8", 102, 109), dans lequel le code de programme comprend en outre des instructions exécutables par ordinateur pour :
• dériver une tâche de balayage à exécuter actuellement par le dispositif d'arpentage 3D (1, 1', 1", 100) et un type de modèle associé d'un modèle numérique d'un environnement à fournir par les données de balayage (105, 105'),
• associer le type de modèle à des critères de visualisation (122-125) pour un affichage d'une représentation d'un aperçu du modèle numérique,
• dériver des unités de traitement minimales (108) pour traiter les données de balayage (105, 105') afin de fournir l'affichage de la représentation de l'aperçu du modèle numérique de manière à ce qu'il réponde aux critères de visualisation (122-125), et
• utiliser un algorithme de priorisation (118) pour fournir une répartition dynamique des différentes affectations de traitement parmi les participants au traitement, dans lequel l'algorithme de priorisation est configuré pour fournir une optimisation (126) en termes de définition et de répartition des différentes affectations de traitement avec un temps court pour fournir les unités de traitement minimales comme valeur cible et avec une bande passante actuellement disponible (119) et une stabilité de connexion (119) d'un échange de données entre les participants au traitement les uns avec les autres, une puissance de calcul actuellement disponible (120, 130, 131, 132) sur chacun des participants au traitement et une énergie de batterie restante (121, 129) sur le dispositif d'arpentage 3D (1, 1', 1", 100) comme paramètres d'entrée.
